# EUROPEAN PATENT APPLICATION

(11) **EP 4 697 369 A1**
(43) Date of publication of application: **18.02.2026**
(21) Application number: 24194107.9
(22) Date of filing: 12.08.2024
(51) Int. Cl.: H01F 27/28, H01F 27/40, H05K 1/14, H05K 1/16, H05K 1/18, B60L 53/20, B60L 53/22, H02M 3/00

(54) **ELECTROMAGNETIC ARRANGEMENT, TRANSFORMER ARRANGEMENT, CHOKE ARRANGEMENT AND CHARGING CONVERTER**

(71) Applicant: Siemens Aktiengesellschaft, 80333 München (DE)
(72) Inventor: Lee, Young Hun, 85598 Baldham (DE); Pavlovsky, Martin, 81675 München (DE); Unterweger, Siegmar, 81549 München (DE)
(74) Representative: Siemens Patent Attorneys

(57) **Abstract**

The invention relates an electromagnetic arrangement (1) configured as an integrated resonant capacitor-inductor-inductor-capacitor arrangement comprising at least:
- a first inductor (4),
- a second inductor (6),
- a first substrate (8),
- a second substrate (10),
- a first resonance capacitor (12), and
- a second resonance capacitor (14),

wherein the first inductor (4) and the first resonance capacitor (12) are arranged on opposite sides (8.1, 8.2) on the first substrate (8) and
wherein the second inductor (6) and the second resonance capacitor (14) are arranged on opposite sides (10.1, 10.2) on the second substrate (10).

The invention further relates to an transformer arrangement, a choke arrangement and a charging converter, each of them comprising the electromagnetic arrangement (1) as defined before.

## Description

The invention relates to an electromagnetic arrangement, a transformer arrangement, a choke arrangement and a charging converter.

Electromagnetic components or elements are essential components in a lot of transformers for charger, e.g. a DC-DC-charger, or in a lot of common mode chokes for a wireless power transfer system (e.g. WPT compensation boards). Usually, the transformers or common mode chokes are used only to get inductance. Needed capacitor boards are provided as separate components.

It is an object of the present invention to provide an improved electromagnetic arrangement, an improved transformer arrangement, an improved choke arrangement and an improved charging converter, e.g. for charging applications.

Regarding the electromagnetic arrangement, the object is achieved by an integrated resonant capacitor-inductor-inductor-capacitor arrangement comprising at least a first inductor, a second inductor, a first substrate, a second substrate, a first resonance capacitor, and a second resonance capacitor, wherein the first inductor and the first resonance capacitor are arranged on opposite sides on the first substrate and wherein the second inductor and the second resonance capacitor are arranged on opposite sides on the second substrate. In particular, the electromagnetic arrangement is a hybrid planar electromagnetic arrangement comprising a planar capacitor-inductor-inductor-capacitor arrangement.

Regarding the transformer arrangement, the object is achieved by a planar transformer arrangement Comprising the electromagnetic arrangement as defined before.

In an embodiment, the transformer may comprise potting material. Potting material or an encapsulant, is a type of insulating material used to encapsulate and protect electrical components of the transformer. It can be a liquid resin that hardens to form a solid, protective layer around the components of the transformer.

In an embodiment, the potting material, the first resonance capacitor and the second resonance capacitor are arranged to each other so that the first resonance capacitor and/or the second resonance capacitor can be cooled by the potting material of the transformer.

Regarding the choke arrangement, the object is achieved by a planar choke arrangement, e.g. a planar common mode choke arrangement, comprising an electromagnetic arrangement as defined before.

Regarding the charging converter, the object is achieved by a planar charging converter comprising the electromagnetic arrangement as defined before.

Preferred embodiments of the invention are given in the dependent claims.

In an embodiment, the first inductor comprises one or more primary windings.

In an embodiment, the second inductor comprises one or more secondary windings.

In an embodiment, the primary and or secondary windings form a coil.

In an embodiment, the first and/or the second substrate are designed as an integrated circuit board or as integrated circuit boards respectively.

According to examples of the present disclosure, the electromagnetic arrangement is configured as an integrated planar resonant capacitor-inductor-inductor-capacitor arrangement. The electromagnetic arrangement has a very compact size and a low and flat profile design and a small size.

The electromagnetic arrangement is produced using substrates, e.g. PCB material (PCB = printed circuit board). The electromagnetic arrangement improves power density and reduces parasitic capacitance as limiting overlapping area. Further, the electromagnetic arrangement reduces leakage inductance due to tight coupling as inductors are configured as planar windings. The invention allows a simplified and cost-effective production.

According to examples of the present disclosure, the first inductor may be configured as a primary winding, e.g. as at least one of a wire winding, a planar winding printed on a first side of the first substrate and winding tracks printed or etched on the first side of the first substrate, in particular spiral PCB coils with litz structure (also called PCB litz coils), e.g. a winding wire/coil having a strand comprising a multiplicity of twisted individual strands. Such a configuration allows a very low profile and small size.

According to examples of the present disclosure, the second inductor may be configured as a secondary winding, e.g. at least one of a wire winding, a planar winding printed on a first side of the second substrate and winding tracks printed or etched on the first side of the second substrate in particular spiral PCB coils with litz structure (also called PCB litz coils), e.g. a winding wire/coil having a strand comprising a multiplicity of twisted individual strands. Such a configuration allows a very low profile and small size.

According to examples of the present disclosure, the first inductor is arranged on a single first core arranged on the first side of the first substrate. The first substrate may be configured as a conventional PCB.

According to examples of the present disclosure, the second inductor is arranged on a single second core arranged on the first side of the second substrate. The second substrate may be configured as a conventional PCB.

According to examples of the present disclosure, at least one of the first core and the second core are made from a dielectric material of the substrate. The first core and/or the second core may be made by using the PCB dielectric material itself by interleaving substrate layers. Alternatively, the first core and/or the second core may be configured as a magnetic planar core. In other words, the first core and/or the second core may be configured as a separate or stand-alone component/s or integrated into a multilayer substrate, e.g. a multilayer PCB with slots for ferrite E-core/s.

According to examples of the present disclosure, the first inductor and the second inductor are arranged between the first substrate and the second substrate. In particular, the first inductor and the second inductor are configured as planar windings or planar coils, e.g. spiral PCB coils. Such configuration allows reducing the coupling between the first inductor as planar primary windings and the second inductor as planar secondary windings.

According to examples of the present disclosure, the first resonance capacitor is arranged on a second side of the first substrate. According to examples of the present disclosure, the second resonance capacitor is arranged on a second side of the second substrate. Due to integration of the first resonance capacitor as well as the second resonance capacitor, the size of the electromagnetic arrangement, in particular of a main substrate (also called main PCB), can be reduced and the overall size of the electromagnetic arrangement can be optimized.

According to examples of the present disclosure, a number of connections, e.g. conventional vias, are provided to interconnect ends of the first inductor as primary windings and/or the second inductor as secondary windings, in particular for circuit interconnections. The connections may be configured as conventional vias, e.g. blind vias and/or buried vias.

According to examples of the present disclosure, substrate dielectric layers are provided as insulating barrier between the first inductor and the second inductor. Alternatively, air gaps may be provided between the first inductor and the second inductor.

According to examples of the present disclosure, the electromagnetic arrangement is partially or fully encapsulated with a substrate material, a molding material or an epoxy material for protection.

The invention allows a low and flat profile design, low leakage inductance, reduced parasitic properties, an easy production and assembly and comprises good thermal characteristics, easy to heatsink due to the planar and integrated capacitor-inductor-inductor-capacitor-design. In particular, this capacitor integrated type planar design reduces the size of a main PCB and optimizes the whole size of the electromagnetic arrangement. Further, the invention reduces the coupling between the first/primary inductor and the second/secondary inductor. Furthermore, the invention allows an integrated planar capacitive-inductor-inductor-capacitive arrangement with uniform winding arrangements and capacitive arrangements. In particular, the invention allows varying design parameters, e.g. winding parameters, winding thickness, core sizes, core layer thickness, layer thickness, airgap, core dimensions, magnetic flux linkage between conductors on primary windings (first inductor) and secondary windings (second inductor), reducing leakage inductances, or combinations thereof.

Further scope of applicability of the present invention will become apparent from the detailed description given hereinafter. However, it should be understood that the detailed description and specific examples, while indicating preferred embodiments of the invention, are given by way of illustration only, since various changes and modifications within the spirit and scope of the invention will become apparent to those skilled in the art from this detailed description.

The present invention will become more fully understood from the detailed description given herein below and the accompanying drawings which are given by way of illustration only, and thus, are not limitative of the present invention, and wherein:
- Figure 1: shows an explanation view of an electromagnetic arrangement, and
- Figure 2: shows a sectional view of the electromagnetic arrangement in an assembled status according to line II-II in figure 1, and
- Figure 3: shows a further sectional view of the electromagnetic arrangement in an assembled status according to line III-III in figure 1.

Reference will now be made in detail to the present embodiments, examples of which are illustrated in the accompanying drawings. Wherever possible, the same reference numbers will be used throughout the drawings to refer to the same or like parts.

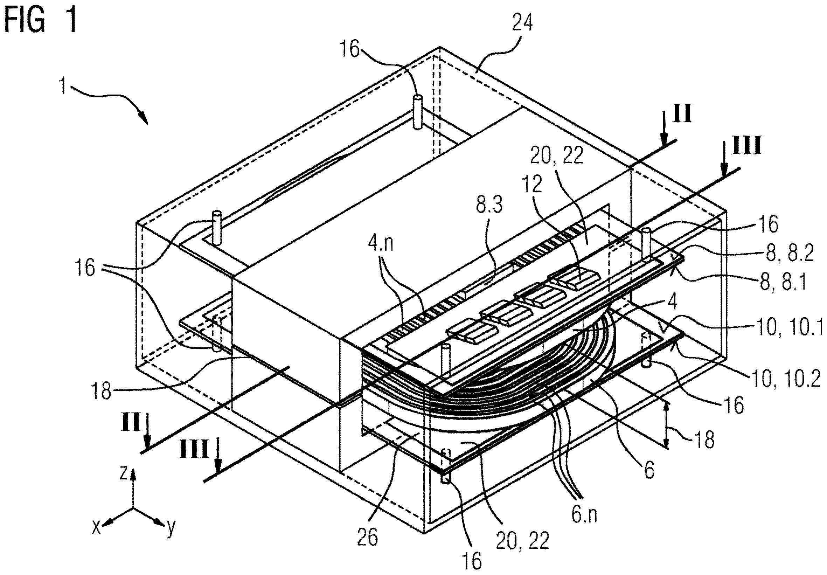

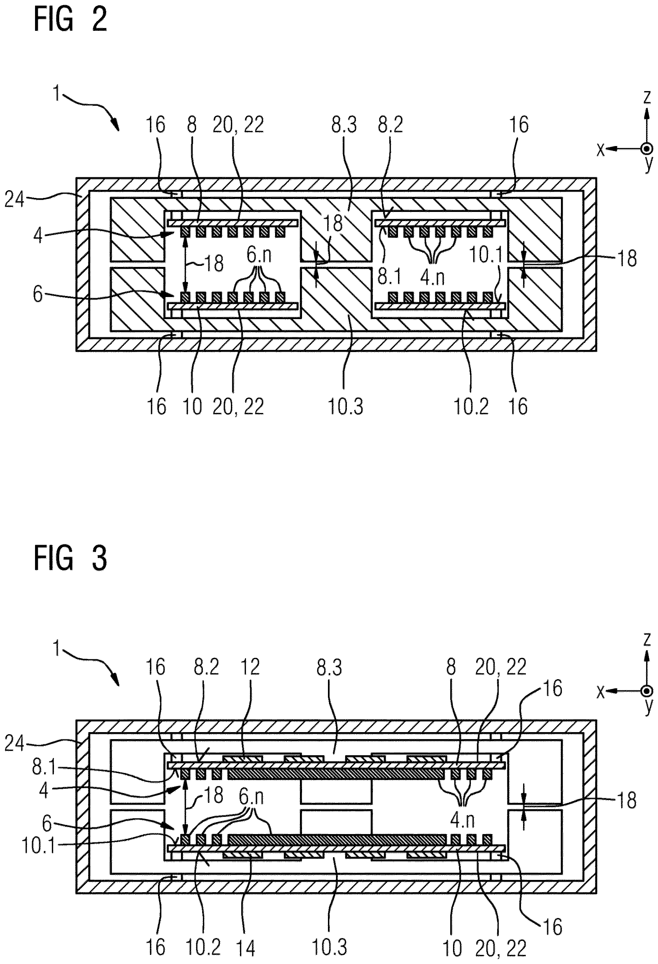

Figure 1 shows an explanation view of an electromagnetic arrangement 1, e.g. for charging applications. Figure 2 shows a sectional view of the electromagnetic arrangement 1 in an assembled status according to line II-II in figure 1, and figure 3 shows a further sectional view of the electromagnetic arrangement 1 in an assembled status according to line III-III in figure 1.

The electromagnetic arrangement 1 is configured as an integrated resonant capacitor-inductor-inductor-capacitor arrangement 2. In particular, the electromagnetic arrangement 1 is a hybrid planar electromagnetic arrangement 1 having a planar resonant capacitor-inductor-inductor-capacitor design. The electromagnetic arrangement 1 has a very compact size and a low and flat profile design and a small size.

The electromagnetic arrangement 1 comprises at least a first inductor 4, a second inductor 6, a first substrate 8, a second substrate 10, a first resonance capacitor 12, and a second resonance capacitor 14.

The first inductor 4 and the first resonance capacitor 12 are arranged on opposite sides 8.1, 8.2 on the first substrate 8. The second inductor 6 and the second resonance capacitor 14 are arranged on opposite sides 10.1, 10.2 on the second substrate 10. The first substrate 8 as well as the second substrate 10 are configured as integrated circuit board, e.g. as a conventional PCB (printed circuit board).

The electromagnetic arrangement 1 is produced using substrates 8, 10, e.g. PCB material. The first inductor 4 may be configured as primary windings 4.n, e.g. as at least one of a wire winding, a planar winding printed on a first side 8.1 of the first substrate 8 and winding tracks printed or etched on the first side 8.1 of the first substrate 8, in particular spiral PCB coils with litz structure (also called PCB litz coils).

The second inductor 6 may be configured as secondary windings 6.n, e.g. at least one of a wire winding, a planar winding printed on a first side 10.1 of the second substrate 10 and winding tracks printed or etched on the first side 10.1, in particular spiral PCB coils with litz structure (also called PCB litz coils), e.g. copper conductors with given size, e.g. minimum copper conductor width and/or minimum copper conductor thickness (height), in particular to achieve the required current flow, the power and/or to ensure temperature conditions.

The first inductor 4 is arranged on a single first core 8.3 arranged on the first side 8.1 of the first substrate 8. The second inductor 6 is arranged on a single second core 10.3 arranged on the first side 10.1 of the second substrate 10. For instance, the first inductor 4 and/or the second inductor 6 may be configured as a winding wire/coil having a strand comprising a multiplicity of twisted individual strands wherein the winding wire/coil is wound around the first core 8.3 and/or the second core 10.3, e.g. four turns, six turns, seven turns (as shown) or a few number of turns.

Alternatively, at least one of the first core 8.3 and the second core 10.3 are partially made from a dielectric material of the substrates 8, 10. The first core 8.3 and/or the second core 10.3 may be made by using the PCB dielectric material itself by interleaving substrate layers. Alternatively, the first core 8.3 and/or the second core 10.3 may be configured as a magnetic planar core/s, e.g. planar ferrite core/s. In other words, the first core 8.3 and/or the second core 10.3 may be configured as a separate or stand-alone component/s or integrated into a multilayer substrate, e.g. a multilayer PCB with slots for ferrite E-core/s.

The first inductor 4 and the second inductor 6 are arranged between the first substrate 8 and the second substrate 10. In particular, the first inductor 4 and the second inductor 6 are configured as planar windings 4.n, 6.n, e.g. planar spiral PCB coils. In particular, the first inductor 4 and the second inductor 6 are arranged opposite each other with a given air gap 18 between them. The first inductor 4 and the second inductor 6 are arranged on the opposite first sides 8.1, 10.1 of the substrates 8, 10. The first sides 8.1, 10.1 are inner sides of the substrates 8, 10.

The first resonance capacitor 12 is arranged on a second side 8.2 of the first substrate 8. The second resonance capacitor 14 is arranged on a second side 10.2 of the second substrate 10. The second sides 8.2, 10.2 are outer sides of the substrates 8, 10.

The primary windings 4.n and the secondary windings 6.n are coupled or connected with the resonance capacitors 12 and 14 with a given resonant frequency, e.g. via connections 16. The connections 16, e.g. conventional vias, are provided to interconnect ends of the first inductor 4 as primary windings 4.n and/or the second inductor 6 as secondary windings 6.n with ends of the first resonance capacitor 12 and/or the second resonance capacitor 14, in particular for circuit interconnections. The connections 16 may be configured as conventional vias, e.g. blind vias and/or buried vias.

Further, air gaps 18 may be provided between the first inductor 4 and the second inductor 6 and/or the cores 8.3 and 10.3. Alternatively, or additionally, substrate dielectric layers 20 may be provided as insulating barrier 22.

Furthermore, the electromagnetic arrangement 1 may be partially or fully encapsulated with a housing 24, e.g. an aluminum case. Alternatively, or additionally, the electromagnetic arrangement 1 may be partially or fully encapsulated with a covering material 26, e.g. a substrate material, a molding material or an epoxy material for protection.

The electromagnetic arrangement 1 as defined before may be configured as a planar transformer arrangement or a planar choke arrangement, e.g. a common mode choke, or a planar charging converter.

In an embodiment, the transformer may comprise potting material. Potting material or an encapsulant, is a type of insulating material used to encapsulate and protect electrical components of the transformer. It can be a liquid resin that hardens to form a solid, protective layer around the components of the transformer.

In an embodiment, the potting material and the capacitors of the electromagnetic arrangement 1 are arranged to each other so that the capacitors can be cooled by the potting material of the transformer.

Independent of the grammatical term usage, individuals with male, female or other gender identities are included within the term.

## Claims

1. An electromagnetic arrangement (1) configured as an integrated resonant capacitor-inductor-inductor-capacitor arrangement comprising at least:
- a first inductor (4)
- a second inductor (6)
- a first substrate (8),
- a second substrate (10),
- a first resonance capacitor (12), and
- a second resonance capacitor (14),
wherein the first inductor (4) and the first resonance capacitor (12) are arranged on opposite sides (8.1, 8.2) on the first substrate (8) and
wherein the second inductor (6) and the second resonance capacitor (14) are arranged on opposite sides (10.1, 10.2) on the second substrate (10).

2. The electromagnetic arrangement (1) according to claim 1,
wherein the first inductor (4) is a primary winding (4.n) configured as at least one of a wire winding, a planar primary winding (4.n) printed on a first side (8.1) of the first substrate (8) and winding tracks printed or etched on the first side (8.1) of the first substrate (8).

3. The electromagnetic arrangement (1) according to claim 1 or 2,
wherein the second inductor (6) is a secondary winding (6.n) configured as at least one of a wire winding, a planar secondary winding (6.n) printed on a first side (10.1) of the second substrate (10) and winding tracks printed or etched on the first side (10.1) of the second substrate (10).

4. The electromagnetic arrangement (1) according to anyone of the preceding claims,
wherein the first inductor (4) is arranged on a single first core (8.3) arranged on the first side (8.1) of the first substrate (8).

5. The electromagnetic arrangement (1) according to anyone of the preceding claims,
wherein the second inductor (6) is arranged on a single second core (10.3) arranged on the first side (10.1) of the second substrate (10).

6. The electromagnetic arrangement (1) according to anyone of the preceding claims,
wherein at least one of the first core (8.3) and the second core (10.3) are made from a dielectric material of the corresponding substrate (8, 10) or made from a magnetic material.

7. The electromagnetic arrangement (1) according to anyone of the preceding claims,
wherein the first inductor (4) and the second inductor (6) are arranged between the first substrate (8) and the second substrate (10).

8. The electromagnetic arrangement (1) according to anyone of the preceding claims,
wherein the first resonance capacitor (12) is arranged on a second side (8.2) of the first substrate (8).

9. The electromagnetic arrangement (1) according to anyone of the preceding claims,
wherein the second resonance capacitor (14) is arranged on a second side (10.2) of the second substrate (10).

10. The electromagnetic arrangement (1) according to anyone of the preceding claims,
wherein a number of connections (16) are provided to interconnect ends of the first inductor (4), the second inductor (6), the first resonance capacitor (12) and/or the second resonance capacitor (14).

11. The electromagnetic arrangement (1) according to anyone of the preceding claims,
wherein substrate dielectric layers (20) are provided as insulating barrier (22) at least between the first inductor (4) and the second inductor (6).

12. The electromagnetic arrangement (1) according to anyone of the preceding claims,
wherein the electromagnetic arrangement (1) is partially or fully encapsulated with a covering material (26).

13. A transformer arrangement is configured as a planar transformer arrangement comprising an electromagnetic arrangement (1) as defined in anyone of the preceding claims.

14. A choke arrangement is configured as a planar choke arrangement comprising an electromagnetic arrangement (1) as defined in anyone of the preceding claims.

15. A charging converter is configured as a planar charging converter comprising an electromagnetic arrangement (1) as defined in anyone of the preceding claims.
